# EUROPEAN PATENT SPECIFICATION

(11) **EP 0 840 955 B1**
(45) Date of publication and mention of the grant of the patent: **21.08.2002**
(21) Application number: 97926506.3
(22) Date of filing: 21.05.1997
(51) Int. Cl.: H03K 3/0231, G06F 1/08

(54) **MICROCONTROLLER WITH FIRMWARE SELECTABLE OSCILLATOR TRIMMING**
MIKROCONTROLLER MIT SYSTEM ZUM FIRMWAREAUSWÄHLBAREN TRIMMEN EINES OSZILLATORS
MICROCONTROLEUR POURVU D'UN SYSTEME D'AJUSTEMENT D'OSCILLATEUR POUVANT ETRE SELECTIONNE PAR MICROLOGICIEL

(30) Priority: 24.05.1996 US 644914
(43) Date of publication of application: 13.05.1998
(73) Proprietor: MICROCHIP TECHNOLOGY INC., Chandler, AZ 85244 (US)
(72) Inventor: HULL, Richard, L., Chandler, AZ 85248 (US); BINGHAM, Gregory, Gilbert, AZ 85233 (US)
(74) Representative: Patry, Didier Marcel Pierre
(86) International application number: PCT/US97/08185
(87) International publication number: WO 97/044904

(56) References cited:
- US-A- 4 964 141
- US-A- 5 036 300
- US-A- 5 272 650
- US-A- 5 583 819
- PATENT ABSTRACTS OF JAPAN vol. 017, no. 061 (E-1316), 5 February 1993 & JP 04 267620 A (NEC CORP), 24 September 1992

## Description

### RELATED APPLICATION

This patent application is related to pending U.S. patent application entitled "Accurate RC Oscillator," having serial number 08/499,602 and a filing date of July 11, 1995, published as US patent US 5 565 819, in the name of Russell E. Cooper as inventor. This patent application is also related to European patent application EP 0 840 952 based on International PCT patent application PCT/US97/07242 (WO 97/45956) entitled "Accurate RC Oscillator Having Peak-to-Peak Voltage Control and Method Therefor," corresponding to US patent US 5 670 915.

### BACKGROUND OF THE INVENTION

### 1. Field of the Invention

This invention is in the field of microcontrollers and methods therefor and, more particularly, is a microcontroller having firmware selectable oscillator trimming and a method therefore.

### 2. Description of the Related Art

In the past, most microcontroller users would rely on external oscillators to provide an accurate clock signal to the microcontroller. This approach has the advantage of yielding an accurate clock signal to the microcontroller, however it has the inherent disadvantages of higher costs associated with using an external clock source and inefficient use of space since an external oscillator and its associated components are required in addition to the microcontroller. Thus, it would be advantageous both in terms of cost reduction and space savings to have an oscillator internal to the microcontroller chip itself, but those skilled in the art know that process variations inherent in the manufacturing procedure for the microcontroller chip typically yield oscillators on the chip that have imprecise output clock frequency.

The patent abstract of Japan Volume 017, No. 061 9E-1316), 5 February 1993 and JP 04 267620 A (NEC Corp.), 24 September 1992, describe a triangle wave oscillation circuit. This circuit comprises peak hold circuits which detect a highest output voltage and a lowest output voltage at a high potential and a low potential of a triangle wave. A difference of setting is detected, a reset/set latch circuit receiving the detection output generates a logic level signal and a timer controls the timing via switches.

US patent 5 036 300 describes an integrated circuit with microprocessor, and in particular an integrated circuit having a processor for the processing of signals, namely a circuit capable of performing data-processing operations under control by instructions.

Therefore, there existed a need to provide a microcontroller having an internal RC oscillator circuit which provides a clock signal for use by the microcontroller that can be modified, as desired, by firmware selectable oscillator trimming of the clock signal frequency and a method therefor.

### SUMMARY OF THE INVENTION

An object of the present invention is to provide a microcontroller having an internal oscillator supplying a clock signal to the microcontroller and a method therefor.

Another object of the present invention is to provide a microcontroller with firmware selectable oscillator trimming of the oscillator clock signal and a method therefor.

### BRIEF DESCRIPTION OF THE PREFERRED EMBODIMENTS

According to the present invention, a microcontroller circuit having firmware selectable oscillator trimming is disclosed comprising, in combination, a microcontroller, oscillator means located within the microcontroller for providing a system clock signal for the microcontroller, and memory means coupled to the oscillator means for providing signals to the oscillator means for trimming frequency of the system clock. The microcontroller circuit further includes microcontroller logic means having trimming data stored therein for providing the trimming data to the memory means. The microcontroller logic means also includes oscillator control means therein for selecting between use of the oscillator means internal to the microcontroller for the system clock and use of an external oscillator source for the system clock.

The microcontroller circuit also includes oscillator logic means coupled to the microcontroller logic means, to the oscillator means, and to the external oscillator source for providing, in response to receipt of a signal from the oscillator control means, the system clock to the microcontroller from one of the oscillator means and the external oscillator source. The memory means comprises Static Random Access Memory (SRAM) having control register means for storing the trimming data and supplying the trimming data to the oscillator means. SRAM address, Data, Read, and Write lines are located between the microcontroller logic means and the SRAM. Additionally, the microcontroller circuit includes a plurality of lines coupling the control register means with the oscillator means for transferring the trimming data to the oscillator means. The microcontroller circuit further includes trimming data adjustment means within the microcontroller logic means for altering the trimming data after the trimming data has been transferred to the memory means.

As an alternative embodiment, a method of operating a microcontroller circuit having firmware selectable oscillator trimming is disclosed comprising the steps of providing a microcontroller, providing a system clock signal to the microcontroller from oscillator means located within the microcontroller, and providing memory means coupled to the oscillator means for providing signals to the oscillator means for trimming frequency of the system clock. The method further includes the step of providing microcontroller logic means having trimming data stored therein for providing the trimming data to the memory means. The step of providing the microcontroller logic means also includes the step of providing oscillator control means therein for selecting between use of the oscillator means internal to the microcontroller for the system clock and use of an external oscillator source for the system clock.

The method further includes the step of providing oscillator logic means coupled to the microcontroller logic means, to the oscillator means, and to the external oscillator source for providing, in response to receipt of a signal from the oscillator control means, the system clock to the microcontroller from one of the oscillator means and the external oscillator source. The step of providing the memory means comprises the step of providing Static Random Access Memory (SRAM) having control register means for storing the trimming data and supplying the trimming data to the oscillator means. SRAM address, Data, Read, and Write lines are provided between the microcontroller logic means and the SRAM. The method also includes the step of providing a plurality of lines coupling the control register means with the oscillator means for transferring the trimming data to the oscillator means. The method further includes the step of providing trimming data adjustment means within the microcontroller logic means for altering the trimming data after the trimming data has been transferred to the memory means.

The foregoing and other objects, features, and advantages of the invention will be apparent from the following, more particular, description of the preferred embodiments of the invention, as illustrated in the accompanying drawing.

### BRIEF DESCRIPTION OF THE DRAWING

Fig. 1 is a simplified block diagram view of the microcontroller with firmware selectable oscillator trimming of the instant invention;
Fig. 2 is a simplified electrical schematic view of the RC oscillator which is located within a microcontroller chip (not shown for simplicity); and
Fig. 3 is a graphical diagram showing an exemplary oscillatory signal of the instant invention.

### DESCRIPTION OF THE PREFERRED EMBODIMENTS

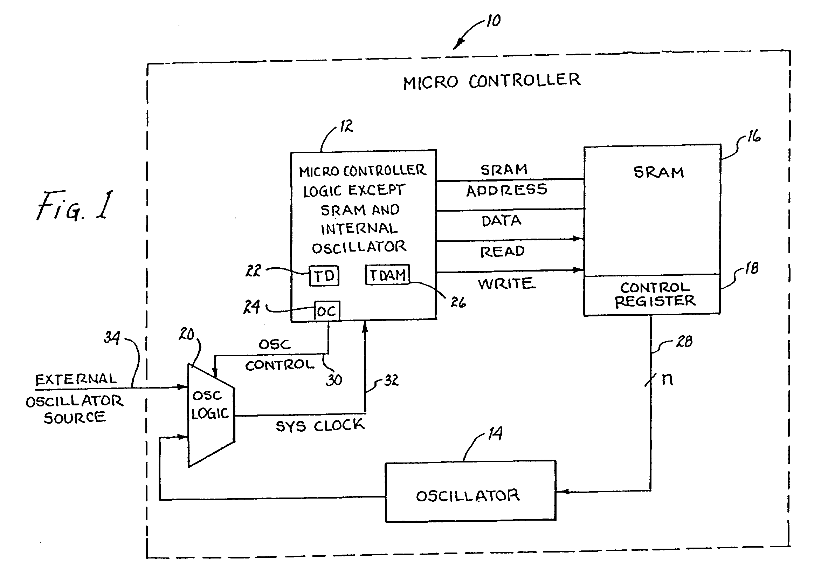

Referring to Figure 1, the microcontroller circuit having firmware selectable oscillator trimming (hereinafter simply referred to as microcontroller) is shown and designated by general reference number 10. Microcontrollers are well known in the art. Most microcontrollers use an external clock source because they are inherently accurate, as compared to providing an internal oscillator, which is inherently accurate, for use by the microcontroller. The instant invention uses an oscillator 14 located within the microcontroller 10 for providing a system clock signal over line 32 to the microcontroller 10. Oscillators are well known in the art; however, providing an oscillator with an accurate clock signal on a microcontroller chip is not well known. Despite being located within the microcontroller 10, oscillator 14 does provide a precise clock signal, and the structure and operation of oscillator 14 is discussed in detail in European patent application EP 0 840 952 based on International PCT patent application PCT/US97/07242 (WO 97/45956) corresponding to US patent US 5 670 915.

The microcontroller 10 also includes a memory portion (SRAM) 16 coupled to the oscillator 14 for providing signals to the oscillator 14 for trimming frequency of the system clock. Note that other types of volatile memory could be implemented in lieu of the SRAM 16. A microcontroller logic portion 12 is also included within the microcontroller 10, and it has trimming data 22 stored therein for providing the trimming data 22 to the memory portion 16. In general, microcontroller logic portion 12 includes logic well known in the art to accomplish basic microcontroller functions. In addition, microcontroller logic portion 12 has a dedicated non-volatile memory location for storing the trimming data 22. The trimming data 22 is determined empirically upon fabrication of the microcontroller 10 to achieve a desired frequency of the clock signal from oscillator 14 for a given set of temperature, voltage, and process variation conditions. In other words, after fabrication of the microcontroller 10, it is tested at various temperatures and voltages, and with the physical variations of the internals of the chip associated with fabrication, to determine what value of trimming data 22 will achieve the desired clock frequency. This value is located within the microcontroller logic portion 12. The microcontroller logic portion 12 also includes an oscillator control portion 24 therein for selecting between use of the oscillator 14 and an external oscillator source 34 for the system clock. The oscillator control portion 24 consists of a non-volatile bit within the microcontroller logic portion 12 set with appropriate data for selecting the desired source for the system clock.

The microcontroller 10 also includes an oscillator logic portion 20 for providing, in response to receipt of a signal from the oscillator control portion 24, the system clock to the microcontroller 10 from either the oscillator 14 or the external oscillator source 34. Logic to accomplish the task of the oscillator logic portion 20 is well known to those skilled in the art; however, while the logic to accomplish this task is well known, the particular function performed by the oscillator logic portion 20, in the context of microcontroller 10, is unique.

As previously noted, the memory portion 16 comprises Static Random Access Memory (SRAM). The SRAM 16 has a control register portion 18 for storing the trimming data 22 and supplying the trimming data 22 to the oscillator 14. The microcontroller 10 further includes SRAM address, Data, Read, and Write lines between the microcontroller logic portion 12 and the SRAM 16. Additionally, a plurality of lines 28 couple the control register portion 18 with the oscillator 14 for transferring the trimming data 22 to the oscillator 14. The microcontroller logic portion 12 further includes a trimming data adjustment portion 26 for permitting a user to alter the trimming data 22 after it has been transferred to the SRAM 16. In practice, a user would take adjustment data provided by the manufacturer to meet the temperature and voltage conditions of his or her application and apply this data to the microcontroller logic portion 12 which would deliver this adjustment data to the SRAM 16 to modify the trimming data 22 accordingly. Logic to accomplish this function is well known to those skilled in the art; however, the practice of adjusting trimming data 22 transferred from the microcontroller logic portion 12 into SRAM 16 is unique.

### OPERATION

Again referring to Figure 1, a user obtains from the manufacture a microcontroller 10 having the trimming data 22 and oscillator control portion 24 set in firmware, as desired. In particular, the user obtains a microcontroller 10 having trimming data 22 set in firmware which is appropriate for the user's application with respect to temperature and voltage conditions, and the process variations associated with the microcontroller 10 itself. Likewise, the user selects a microcontroller 10 having the appropriate data set in firmware for the oscillator control portion 24 such that the user can provide the system clock to the microcontroller 10 from either oscillator 14 or the external oscillator source 34, as desired.

Upon appropriate command, well known in the art, from the user, the oscillator control portion 24 provides a signal over line 30 to the oscillator logic portion 20 to select the source for the system clock from either the oscillator 14 or the external oscillator source 34. Thereafter, the system clock is provided from the output of the oscillator logic portion 20 for use by the microcontroller 10.

Again, upon appropriate command, well known in the art, from the user, the trimming data 22 is transferred from the microcontroller logic portion 12 to the SRAM 16, and more particularly into the control register portion 18. The trimming data 22 in the control register portion 18 is automatically fed to the oscillator 14 over lines 28. As previously mentioned, the particular operation of oscillator 14 is described in European patent application EP 0 840 952 based on International PCT patent application PCT/US97/07242 (WO 97/45956) corresponding to US 5 670 915. However, note that operation of the oscillator 14 with the trimming data 22 transferred therein yields a substantially precise system clock frequency in spite of the fact that oscillator 14 is integral to the microcontroller 10 chip.

The aforementioned loading of trimming data 22 into the oscillator 14 assumes that the user is satisfied with the value of trimming data 22 in firmware of the microcontroller logic portion 12. This is not always the case. A user may want to adjust the operating frequency of the system clock by trimming a small amount, or even by changing the frequency by a large amount. Accordingly, the microcontroller logic portion 12 further includes a trimming data adjustment portion 26 for permitting a user to alter the trimming data 22 after it has been transferred into the SRAM 16. In practice, a user would take adjustment data provided by the manufacturer to meet the temperature and voltage conditions of his or her application and, using commands well known to those skilled in the art, apply this data to the microcontroller logic portion 12 which would deliver this adjustment data to the SRAM 16 to modify the trimming data 22 accordingly. Last, note that communication protocol over the SRAM Address, Data, Read, and Write lines is well known to those skilled in the art, and therefore, the particulars of transferring data, whether it be trimming data 22, data from the trimming data adjustment portion 26, or otherwise, between the microcontroller logic portion 12 and the SRAM 16 are well known to those skilled in the art.

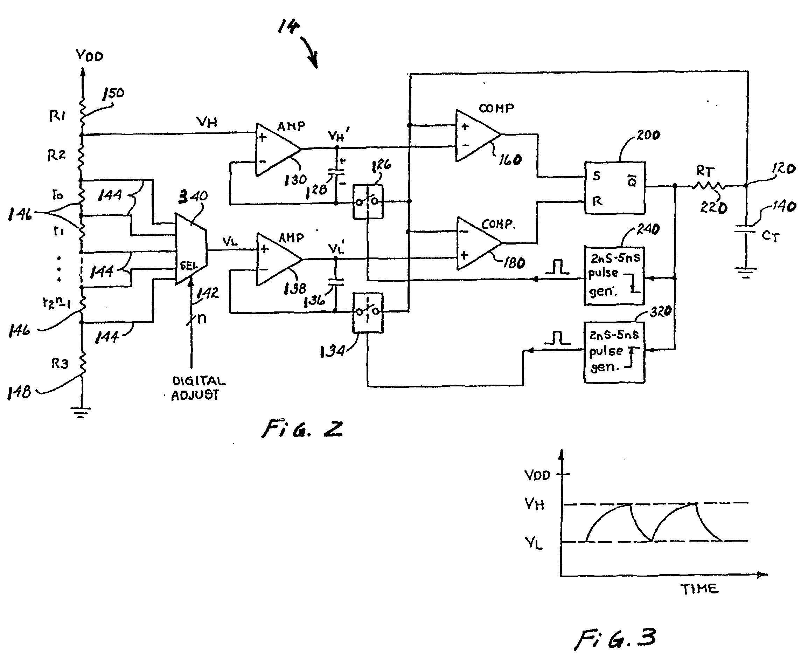

Referring to Figure 2, the accurate RC oscillator having peak-to-peak voltage control (hereinafter referred to simply as the oscillator) is shown and designated by general reference number 14. The oscillator 14 is situated on a chip with a microcontroller (not shown), and this is a key feature of the claimed invention since no external, separate oscillator is required with the microcontroller of the instant invention. The oscillator 14 generates an oscillatory signal of a predetermined frequency by accurately oscillating between precise predetermined voltage levels, for example, predetermined first and second or high and low voltages (Vh and Vl), respectively. The oscillator 14 generates an oscillatory signal at circuit node 120 (i.e., across capacitor 140), that accurately oscillates between high and low voltage values (Vh and Vl). The frequency of oscillation is determined, in part, by the RC time constant of the resistor 220 and the capacitor 140 wherein the frequency of oscillation is inversely proportional to the product of the resistance and capacitance associated with resistor 220 and capacitor 140, respectively. The frequency of oscillation is also affected by the difference between the high and low voltages (Vh and Vl) since the oscillatory signal at node 120 precisely alternates, peak-to-peak between these voltages. More particularly, for a given RC time constant associated with resistor 220 and capacitor 140, as the voltage difference between Vh and Vl becomes lower, the frequency of oscillation increases, and vice versa.

The oscillator 14 includes comparators 160 and 180 and SR flip flop 200 all of which comprise the components of a conventional 555 timer. Comparators 160 and 180 have outputs respectively coupled to the set and reset inputs of SR flip flop 200, which can be thought of as a charging-discharging portion for the oscillator 14. Circuit node 120, which is the interconnection of the RC network comprised of capacitor 140 and resistor 220, is coupled to the non-inverting input of comparator 160 and the inverting input of comparator 180. The inverting input of comparator 160 is coupled to receive a modified version of the high voltage (Vh), as represented by high threshold voltage (Vh'). Likewise, the non-inverting input of comparator 180 is coupled to receive a modified version of the low voltage (Vl), as represented by low threshold voltage (Vl').

An inverting output flip flop 200 is coupled through resistor 220 to circuit node 120. The output of flip flop 200 switches between the supply voltages applied to flip flop 200, for example, between commonly referred to voltages of Vdd and Vss, depending on whether the flip flop is being set or reset. For example, when flip flop 200 is set, the inverting output of flip flop 200 switches form a logic 1 to a logic 0 and, thus, transitions from voltage Vdd to voltage Vss.

It is noteworthy that although the preferred embodiment utilizes the inverting output of flip flop 200, the non-inverting output (not shown) of flip flop 200 could have been used wherein the connections from comparators 160 and 180 to the set and reset inputs of flip flop 200 would be reversed. Alternative, the inputs of each comparator 160 and 180 could be swapped to provide inverted polarity at their respective outputs.

The oscillator 14 includes a first voltage modifying portion comprising a first sampling portion and a first compensation portion. Similarly, the oscillator 14 includes a second voltage modifying portion comprising a second sampling portion and a second compensation portion. The first and second voltage modifying portions generate modified high and low threshold voltages (Vh' and Vl') for application to comparators 160 and 180, respectively, based upon the overshoot (of voltage Vh) or undershoot (of voltage Vl) of the oscillatory signal appearing at circuit node 120 when flip flop 200 switches. In particular, the first voltage modifying portion generates and applies a modified high threshold voltage Vh' to the inverting input of comparator 160 so that the time flip flop 200 actually switches in response to the oscillatory signal exceeding modified high threshold voltage Vh', the oscillatory signal is substantially equal to the predetermined high voltage Vh. Similarly, the second voltage modifying portion generates and applies a modified low threshold voltage Vl' to the non-inverting input of comparator 180 so that by the time flip flop 200 actually switches in response to the oscillatory signal falling below modified low threshold voltage Vl', the oscillatory signal is substantially equal to the predetermined low voltage Vl. In this manner, the instant invention provides a signal appearing at circuit node 120 that accurately oscillates between voltages Vl and Vh. This ensures that the signal at circuit node 120 oscillates at a predetermined and substantially constant frequency.

As previously stated, the first voltage modifying portion includes the first sampling portion and the first compensation portion. The first sampling portion comprises a negatively-triggered pulse generator 240 having an input connected to an output of the charging-discharging portion or flip flop 200, and a first switch portion 126 coupled to an output of the negatively triggered pulse generator 240 for momentarily coupling, in response to receipt of a pulse from the negatively-triggered pulse generator 240, the first compensation portion to a first sampled voltage of the oscillatory signal. The negatively triggered pulse generator 240 provides an output pulse of approximately 2-5 nanosecond duration in response to receipt at its input of the falling edge of the output signal from flip flop 200. Pulse generators such as negatively triggered pulse generator 240 are well known to those skilled in the art. The first compensation portion comprises an amplifier 130 and a capacitor 128. The first input of the amplifier 130 is coupled to receive the first or high voltage (Vh), and the output of the amplifier 130 is coupled to the inverting input of the first comparator 160. The capacitor 128 is coupled at one end to the output of the amplifier 130, and coupled at the other end to the second input of the amplifier 130.

In operation, amplifier 130 is coupled in a unity gain configuration with feedback capacitor 128 such that the voltage across capacitor 128 is the voltage difference between Vh' and Vh, since amplifier 130 maintains the voltages appearing at its inverting and non-inverting inputs substantially equal. Further, voltage Vh' is initially set to equal voltage Vh. However, when flip flop 200 switches from a logic high to a logic low, switch 126 momentarily closes (due to negatively triggered pulse generator 240) and connects circuit node 120 to a first terminal of capacitor 128. This forces a sample of the voltage appearing at circuit node 120 (i.e., voltage of the oscillatory signal) to appear at the first terminal of capacitor 128. Accordingly, the voltage across capacitor 128 will change by the difference between the voltage sampled at circuit node 120 and voltage Vh such that the voltage across the capacitor becomes more positive if Vh > (voltage at circuit node 120) and less positive if Vh < (voltage at circuit node 120). In this manner, the capacitor 128 effectively stores this voltage difference. Moreover, once Vh = (voltage at circuit node 120) at the sample time, the voltage across capacitor 128 will not change and the overshoot condition will have been corrected.

In particular, when the oscillatory signal overshoots voltage Vh, the first sampled voltage appearing at the first terminal of capacitor 128 will be greater than voltage Vh. Accordingly, amplifier 130 will respond by lowering the voltage across capacitor 128, and, thus, lowering voltage Vh' by the amount of the voltage overshoot. In other words, amplifier 130 generates modified high threshold voltage Vh' that is equal to the voltage difference between the first sampled voltage at circuit node 120 and voltage Vh and applies this voltage Vh' to comparator 160. Moreover, because the sample time is very short (i.e., on the order of 2-5 nanoseconds), it may take a few iterations from start-up before the oscillatory signal precisely reaches the high voltage Vh without overshoot. Thereafter, however, comparator 160 will switch when the voltage at circuit node 120 exceeds voltage Vh' such that by the time flip flop 200 actually switches and begins to discharge the voltage at circuit node 120, the voltage at circuit node 120 has accurately and precisely reached the desired high value of Vh.

Similarly, as previously stated, the second voltage modifying portion includes the second sampling portion and the second compensation portion. The second sampling portion comprises a positively-triggered pulse generator 320 having an input connected to an output of the charging-discharging portion or flip flop 200, and a second switch portion or simply switch 134 coupled to an output of the positively-triggered pulse generator 320 for momentarily coupling, in response to receipt of a pulse from the positively-triggered pulse generator 320, the second compensation portion to a second sampled voltage of the oscillatory signal. The positively triggered pulse generator 320 provides an output pulse of approximately 2-5 nanosecond duration in response to receipt at its input of the rising edge of the output signal from flip flop 200. Pulse generators such as positively triggered pulse generator 320 are well known to those skilled in the art. The second compensation portion comprises an amplifier 138 and a capacitor 136. The first input of the amplifier 138 is coupled to receive the second or low voltage (Vl), and the output of the amplifier 138 is coupled to the non-inverting input of the second comparator 180. The capacitor 136 is coupled at one end to the output of the amplifier 138, and coupled at the other end to the second input of the amplifier 138.

Similar to amplifier 130, amplifier 138 is coupled in a unity gain configuration with feedback capacitor 136 such that the voltage across capacitor 136 is the voltage difference between Vl' and Vl. Further, voltage Vl' is initially set to equal voltage Vl. When flip flop 200 switches from a logic low to a logic high, switch 134 momentarily closes (due to positively triggered pulse generator 320) and connects circuit node 120 to the first terminal of capacitor 136. This forces a sample of the voltage appearing at circuit node 120 to appear at the first terminal of capacitor 136. Accordingly, the voltage across capacitor 136 will change by the difference between the voltage sampled at circuit node 120 and voltage Vl, and capacitor 136 effectively stores this voltage difference. For example, when the oscillatory signal undershoots voltage Vl, the sampled voltage appearing at the first terminal of capacitor 136 will be less than voltage Vl. Accordingly, amplifier 138 will respond by increasing the voltage across capacitor 136 and, increasing voltage Vl' by the voltage amount equal to the voltage difference between the second sampled voltage and voltage Vl and apply this voltage to comparator 180. Again, because the sample time is very short (i.e., 2-5 nanoseconds), it may take a few iterations before the oscillatory signal precisely reaches the low voltage Vl with no undershoot. Thereafter, comparator 180 will switch when the voltage at circuit node 120 exceeds voltage Vl' such that by the time flip flop 200 actually switches and begins to charge the voltage at circuit node 120, the voltage at circuit node 120 has accurately reached the desired low voltage Vl.

The portions of the oscillator 14 discussed up until this point provide a signal which oscillates at a predetermined frequency between low and high voltages Vl and Vh. Since the frequency of the oscillating signal is a function of both the RC time constant associated with resistor 220 and capacitor 140 and the voltage difference between the voltages Vl and Vh, controlling this voltage difference will also control the frequency of the oscillating signal from the oscillator 14. Thus, the differential voltage setting portion is provided for selecting the second or low voltage (Vl) from a plurality of different possible voltages, thereby selecting the voltage difference between the first or high (Vh) and second or low (Vl) voltages. The differential voltage setting portion comprises a multiplexer 340 coupled at an input thereof to the supply voltage source Vdd and having an output supplying the second or low voltage (Vl) to amplifier 138 of the second compensation portion. The multiplexer 340 has a plurality of input taps 144 each supplying a different voltage from the multiplexer 340 to the amplifier 138 when selected. The multiplexer 340 includes a selection or digital adjust portion 142 for selecting one of the plurality of input taps 144. The digital adjust portion 142 comprises n lines of digital data for the multiplexer 340. Thus, the digital adjust portion 142 can address 2ⁿ input taps 144 from R0 to (2ⁿ-1). Between each input tap 144 is another resistor 146 to provide different voltage levels to the multiplexer 340. Also note that between the voltage source Vdd and ground are setting resistors 148 and 150. The digital adjust portion 142 data can be provided from memory on the microcontroller chip or from other sources, as desired.

Referring to Figure 3 a graphical diagram shows an exemplary oscillatory signal of the instant invention wherein the signal oscillates between predetermined high and low voltages Vh and Vl.

## Claims

1. A microcontroller circuit having firmware selectable oscillator trimming comprising:
a microcontroller (10);
wherein said microcontroller circuit comprises, in combination with said microcontroller (10), oscillator means (14) located within said microcontroller (10) for providing a system clock signal for said microcontroller (10), wherein said oscillator means (14) generating an oscillatory signal of a predetermined frequency across a series resistor-capacitor (RC) network by ensuring that the oscillatory signal accurately oscillates between first and second voltages generated from a supply voltage source where the frequency of oscillation is determined by both the time constant of the RC network and the difference between the first and second voltages, said oscillator means (14) comprising, in combination:
charging-discharging means (200) for discharging a voltage across the capacitor (140) commencing when voltage of the oscillatory signal exceeds a first threshold voltage and for charging said voltage across the capacitor (140) commencing when voltage of the oscillatory signal falls below a second threshold voltage;
first sampling means (240, 126) coupled to said charging-discharging means (200) for obtaining a first sampled voltage of the oscillatory signal upon commencement of discharging of said voltage across the capacitor (140);
first compensation means (130, 128) coupled to said first sampling means (240, 126) for adjusting said first threshold voltage to be the first voltage modified by a voltage difference between the first voltage and said first sampled voltage;
second sampling means (320, 134) coupled to said charging-discharging means (200) for obtaining a second sampled voltage of the oscillatory signal upon commencement of charging of said voltage across the capacitor (140);
second compensation means (138, 136) coupled to said second sampling means (320, 134) for adjusting said second threshold voltage to be the second voltage modified by a voltage difference between the second voltage and said second sampled voltage; and
differential voltage setting means (340) coupled to said second compensation means (138, 136) for selecting the second voltage from a plurality of different possible voltages and thereby selecting a voltage difference between the first and second voltages; and
memory means (16) coupled to said oscillator means (14) for providing signals to said oscillator means (14) for trimming frequency of said system clock.

2. The microcontroller circuit of Claim 1 further including microcontroller logic means (12) having trimming data (22) stored therein for providing said trimming data (22) to said memory means (16).

3. The microcontroller circuit of Claim 2 wherein said microcontroller logic means (12) also includes oscillator control means (24) therein for selecting between use of said oscillator means (14) internal to said microcontroller (10) for said system clock and use of an external oscillator source (34) for said system clock.

4. The microcontroller circuit of Claim 3 further including oscillator logic means (20) coupled to said microcontroller logic means (12), to said oscillator means (14), and to said external oscillator source (34) for providing, in response to receipt of a signal from said oscillator control means (24), said system clock to said microcontroller (10) from one of said oscillator means (14) and said external oscillator source (34).

5. The microcontroller circuit of Claim 2 wherein said memory means (16) comprises Static Random Access Memory (SRAM) having control register means (18) for storing said trimming data (22) and supplying said trimming data (22) to said oscillator means (14).

6. The microcontroller circuit of Claim 5 further including SRAM address, data, read, and write lines between said microcontroller logic means (12) and said SRAM.

7. The microcontroller circuit of Claim 5 further including a plurality of lines coupling said control register means (18) with said oscillator means (14) for transferring said trimming data (22) to said oscillator means (14).

8. The microcontroller circuit of Claim 1 wherein said memory means (16) is located within said microcontroller (10).

9. The microcontroller circuit of Claim 2 further including trimming data (22) adjustment means within said microcontroller logic means (12) for altering said trimming data (22) after said trimming data (22) has been transferred to said memory means (16).

10. A method of operating a microcontroller circuit having firmware selectable oscillator trimming comprising the steps of:
providing a microcontroller (10);
providing a system clock signal to said microcontroller (10) wherein said method further comprises the step of providing said system clock signal from oscillator means (14) located within said microcontroller (10), said oscillator means (14) generating an oscillatory signal of a predetermined frequency across a series resistor-capacitor (RC) network by ensuring that the oscillatory signal accurately oscillates between first and second voltages generated from a supply voltage source where the frequency of oscillation is determined by both the time constant of the RC network and the difference between the first and second voltages, said oscillator means (14) comprising, in combination:
charging-discharging means (200) for discharging a voltage across the capacitor (140) commencing when voltage of the oscillatory signal exceeds a first threshold voltage and for charging said voltage across the capacitor (140) commencing when voltage of the oscillatory signal falls below a second threshold voltage;
first sampling means (240, 126) coupled to said charging-discharging means (200) for obtaining a first sampled voltage of the oscillatory signal upon commencement of discharging of said voltage across the capacitor (140);
first compensation means (130, 128) coupled to said first sampling means (240, 126) for adjusting said first threshold voltage to be the first voltage modified by a voltage difference between the first voltage and said first sampled voltage;
second sampling means (320, 134) coupled to said charging-discharging means (200) for obtaining a second sampled voltage of the oscillatory signal upon commencement of charging of said voltage across the capacitor (140);
second compensation means (138, 136) coupled to said second sampling means (320, 134) for adjusting said second threshold voltage to be the second voltage modified by a voltage difference between the second voltage and said second sampled voltage; and
differential voltage setting means (340) coupled to said second compensation means (138, 136) for selecting the second voltage from a plurality of different possible voltages and thereby selecting a voltage difference between the first and second voltages; and
providing memory means (16) coupled to said oscillator means (14) for providing signals to said oscillator means (14) for trimming frequency of said system clock.

11. The method of Claim 10 further including the step of providing microcontroller logic means (12) having trimming data (22) stored therein for providing said trimming data (22) to said memory means (16).

12. The method of Claim 11 wherein said step of providing said microcontroller logic means (12) also includes the step of providing oscillator control means (24) therein for selecting between use of said oscillator means (14) internal to said microcontroller (10) for said system clock and use of an external oscillator source (34) for said system clock.

13. The method of Claim 12 further including the step of providing oscillator logic means (20) coupled to said microcontroller logic means (12), to said oscillator means (14), and to said external oscillator source (34) for providing, in response to receipt of a signal from said oscillator control means (24), said system clock to said microcontroller (10) from one of said oscillator means (14) and said external oscillator source (34).

14. The method of Claim 11 wherein said step of providing said memory means (16) comprises the step of providing Static Random Access Memory (SRAM) having control register means (18) for storing said trimming data (22) and supplying said trimming data (22) to said oscillator means (14).

15. The method of Claim 14 further including the step of providing SRAM address, data, read, and write lines between said microcontroller logic means (12) and said SRAM.

16. The method of Claim 14 further including the step of providing a plurality of lines coupling said control register means (18) with said oscillator means (14) for transferring said trimming data (22) to said oscillator means (14).

17. The method of Claim 10 wherein said memory means (16) is located within said microcontroller (10).

18. The method of Claim 11 further including the step of providing trimming data (22) adjustment means within said microcontroller logic means (12) for altering said trimming data (22) after said trimming data (22) has been transferred to said memory means (16).

19. A microcontroller circuit having firmware selectable oscillator trimming comprising, in combination:
a microcontroller (10);
wherein said microcontroller circuit comprises, in combination with said microcontroller (10), oscillator means (14) located within said microcontroller (10) for providing a system clock signal for said microcontroller (10), wherein said oscillator means (14) generating an oscillatory signal of a predetermined frequency across a series resistor-capacitor (RC) network by ensuring that the oscillatory signal accurately oscillates between first and second voltages generated from a supply voltage source where the frequency of oscillation is determined by both the time constant of the RC network and the difference between the first and second voltages, said oscillator means (14) comprising, in combination:
charging-discharging means (200) for discharging a voltage across the capacitor (140) commencing when voltage of the oscillatory signal exceeds a first threshold voltage and for charging said voltage across the capacitor (140) commencing when voltage of the oscillatory signal falls below a second threshold voltage;
first sampling means (240, 126) coupled to said charging-discharging means (200) for obtaining a first sampled voltage of the oscillatory signal upon commencement of discharging of said voltage across the capacitor (140);
first compensation means (130, 128) coupled to said first sampling means (240, 126) for adjusting said first threshold voltage to be the first voltage modified by a voltage difference between the first voltage and said first sampled voltage;
second sampling means (320, 134) coupled to said charging-discharging means (200) for obtaining a second sampled voltage of the oscillatory signal upon commencement of charging of said voltage across the capacitor (140);
second compensation means (138, 136) coupled to said second sampling means (320, 134) for adjusting said second threshold voltage to be the second voltage modified by a voltage difference between the second voltage and said second sampled voltage; and
differential voltage setting means (340) coupled to said second compensation means (138, 136) for selecting the second voltage from a plurality of different possible voltages and thereby selecting a voltage difference between the first and second voltages;
memory means (16) coupled to said oscillator means (14) for providing signals to said oscillator means (14) for trimming frequency of said system clock;
microcontroller logic means (12) having trimming data (22) stored therein for providing said trimming data (22) to said memory means (16);
said microcontroller logic means (12) also including oscillator control means (24) therein for selecting between use of said oscillator means (14) internal to said microcontroller (10) for said system clock and use of an external oscillator source (34) for said system clock;
oscillator logic means (20) coupled to said microcontroller logic means (12), to said oscillator means (14), and to said external oscillator source (34) for providing, in response to receipt of a signal from said oscillator control means (24), said system clock to said microcontroller (10) from one of said oscillator means (14) and said external oscillator source (34);
said memory means (16) comprising Static Random Access Memory (SRAM) having control register means (18) for storing said trimming data (22) and supplying said trimming data (22) to said oscillator means (14); and
trimming data adjustment means within said microcontroller logic means (12) for altering said trimming data (22) after said trimming data (22) has been transferred to said memory means (16).

## Patentansprüche

1. Mikrocontroller-Schaltung mit Firmware-auswählbarer Oszillatortrimmung, aufweisend:
einen Mikrocontroller (10) ;
**dadurch gekennzeichnet, dass** die Mikrocontrollerschaltung in Kombination mit dem Mikrocontroller (10) aufweist eine Oszillatoreinrichtung (14), die in dem Mikrocontroller (10) zum Bereitstellen eines Systemtaktsignals für den Mikrocontroller (10) angeordnet ist, wobei die Oszillatoreinrichtung (14) ein oszillierendes Signal mit einer vorbestimmten Frequenz über ein in Reihe geschaltetes Widerstands-Kondensator-(RC)-Netz durch Sicherstellen erzeugt, dass das oszillierende Signal genau zwischen einer ersten und einer zweiten Spannung oszilliert, die von einer Speisespannungsquelle erzeugt werden, wobei die Frequenz der Oszillation durch sowohl die Zeitkonstante des RC-Netzes als auch die Differenz zwischen der ersten und der zweiten Spannung bestimmt wird, wobei die Oszillatoreinrichtung (14) in Kombination aufweist:
eine Ladungs-Entladungs-Einrichtung (200) zum Entladen einer Spannung über den Kondensator (140), beginnend, wenn die Spannung des oszillierenden Signals eine erste Schwellenspannung überschreitet, und zum Laden der Spannung über den Kondensator (140), beginnend, wenn die Spannung des oszillierenden Signals unter eine zweite Schwellenspannung fällt;
eine erste Abtasteinrichtung (240, 126), die mit der Ladungs-Entladungs-Einrichtung (200) zum Erhalten einer ersten abgetasteten Spannung des oszillierenden Signals nach dem Beginn des Entladens der Spannung über den Kondensator (140) gekoppelt ist;
eine erste Kompensationseinrichtung (130, 128), die mit der ersten Abtasteinrichtung (240, 126) zum Einstellen der ersten Schwellenspannung zu der ersten Spannung, welche durch eine Spannungsdifferenz zwischen der ersten Spannung und der ersten abgetasteten Spannung modifiziert wird, gekoppelt ist;
eine zweite Abtasteinrichtung (320, 134), die mit der Ladungs-Entladungs-Einrichtung (200) zum Erzielen einer zweiten abgetasteten Spannung des oszillierenden Signals nach dem Beginn des Ladens der Spannung über den Kondensator (140) gekoppelt ist;
eine zweite Kompensationseinrichtung (138, 136), die mit der zweiten Abtasteinrichtung (320, 134) zum Einstellen der zweiten Schwellenspannung zu der zweiten Spannung gekoppelt ist, die durch eine Spannungsdifferenz zwischen der zweiten Spannung und der zweiten abgetasteten Spannung modifiziert wird; und
eine Differenzspannungs-Einstelleinrichtung (340), die mit der zweiten Kompensationseinrichtung (138, 136) zum Auswählen der zweiten Spannung aus einer Vielzahl von verschiedenen möglichen Spannungen gekoppelt ist und dadurch eine Spannungsdifferenz zwischen der ersten und der zweiten Spannung auswählt; und
eine Speichereinrichtung (16), die mit der Oszillatoreinrichtung (14) zum Bereitstellen von Signalen für die Oszillatoreinrichtung (14) zum Trimmen der Frequenz des Systemtaktes gekoppelt ist.

2. Mikrocontroller-Schaltung nach Anspruch 1, ferner einschließend eine Mikrocontroller-Logikeinrichtung (12) mit darin zum Bereitstellen der Trimmdaten (22) für die Speichereinrichtung (16) gespeicherten Trimmdaten (22).

3. Mikrosteuer-Schaltung nach Anspruch 2, wobei die Mikrosteuer-Logikeinrichtung (12) darin auch eine Oszillator-Steuereinrichtung (24) zum Auswählen zwischen der Verwendung der Oszillatoreinrichtung (14) in dem Mikrocontroller (10) für den Systemtakt und der Verwendung einer externen Oszillatorquelle (34) für den Systemtakt einschließt.

4. Mikrocontroller-Schaltung nach Anspruch 3, ferner einschließend eine Oszillator-Logikeinrichtung (20), die mit der Mikrocontroller-Logikeinrichtung (12), der Oszillatoreinrichtung (14) und der externen Oszillatorquelle (34) zum Bereitstellen des Systemtakts für den Mikrocontroller (10) von einer, von der Oszillatoreinrichtung (14) und der externen Oszillatorquelle (34) in Erwiderung auf den Empfang eines Signals von der Oszillator-Steuereinrichtung (24) gekoppelt ist.

5. Mikrocontroller-Schaltung nach Anspruch 2, wobei die Speichereinrichtung (16) einen statischen Direktzugriffsspeicher (SRAM) mit einer Steuerregistereinrichtung (18) zum Speichern der Trimmdaten (22) und Zuführen der Trimmdaten (22) zu der Oszillatoreinrichtung (14) aufweist.

6. Mikrocontroller-Schaltung nach Anspruch 5, ferner einschließend SRAM-Adress-, Daten-, Lese- und Schreib-Leitungen zwischen der Mikrocontroller-Logikeinrichtung (12) und dem SRAM.

7. Mikrocontroller-Schaltung nach Anspruch 5, ferner einschließend eine Vielzahl von Leitungen, welche die Steuerregistereinrichtung (18) mit der Oszillatoreinrichtung (14) zum Übertragen der Trimmdaten (22) zu der Oszillatoreinrichtung (14) koppeln.

8. Mikrocontroller-Schaltung nach Anspruch 1, wobei die Speichereinrichtung (16) innerhalb des Mikrocontrollers (10) angeordnet ist.

9. Mikrocontroller-Schaltung nach Anspruch 2, ferner einschließend eine Trimmdaten-(22)-Einstelleinrichtung innerhalb der Mikrocontroller-Logikeinrichtung (22) zum Ändern der Trimmdaten (22), nachdem die Trimmdaten (22) zu der Speichereinrichtung (16) übertragen wurden.

10. Verfahren zum Betreiben einer Mikrocontroller-Schaltung mit Firmware-auswählbarer Oszillatortrimmung, aufweisend die Schritte:
Bereitstellen eines Mikrocontrollers (10);
Bereitstellen eines Systemtaktsignals für den Mikrocontroller (10), **dadurch gekennzeichnet, dass** das Verfahren ferner aufweist den Schritt des Bereitstellens des Systemtaktsignals von einer Oszillatoreinrichtung (14), die innerhalb des Mikrocontrollers (10) angeordnet ist, wobei die Oszillatoreinrichtung (14) ein oszillierendes Signal mit einer vorbestimmten Frequenz über ein in Reihe geschaltetes Widerstands-Kondensator-(RC)-Netz durch Sicherstellen erzeugt, dass das oszillierende Signal genau zwischen einer ersten und einer zweiten Spannung oszilliert, welche von einer Speisespannungsquelle erzeugt werden, wobei die Oszillationsfrequenz durch sowohl die Zeitkonstante des RC-Netzes als auch die Differenz zwischen der ersten und zweiten Spannung bestimmt wird, wobei die Oszillatoreinrichtung (14) in Kombination aufweist:
eine Ladungs-Entladungs-Einrichtung (200) zum Entladen einer Spannung über den Kondensator (140), beginnend, wenn die Spannung des oszillierenden Signals eine erste Schwellenspannung überschreitet, und zum Laden der Spannung über den Kondensator (140), beginnend, wenn die Spannung des oszillierenden Signals unter eine zweite Schwellenspannung fällt;
eine erste Abtasteinrichtung (240, 126), die mit der Ladungs-Entladungs-Einrichtung (200) zum Erzielen einer ersten abgetasteten Spannung des oszillierenden Signals nach dem Beginn des Entladens von der Spannung über den Kondensator (140) gekoppelt ist;
eine erste Kompensationseinrichtung (130, 128), die mit der ersten Abtasteinrichtung (240, 126) zum Einstellen der ersten Schwellenspannung zu der ersten Spannung gekoppelt ist, welche durch eine Spannungsdifferenz zwischen der ersten Spannung und der ersten abgetasteten Spannung modifiziert wird;
eine zweite Abtasteinrichtung (320, 134), die mit der Ladungs-Entladungs-Einrichtung (200) zum Erzielen einer zweiten abgetasteten Spannung des oszillierenden Signals nach dem Beginn des Ladens der Spannung über den Kondensator (140) gekoppelt ist;
eine zweite Kompensationseinrichtung (138, 136), die mit der zweiten Abtasteinrichtung (320, 134) zum Einstellen der zweiten Schwellenspannung zu der zweiten Spannung gekoppelt ist, die durch eine Spannungsdifferenz zwischen der zweiten Spannung und der zweiten abgetasteten Spannung modifiziert wird; und
eine Differenzspannungs-Einstelleinrichtung (340), die mit der zweiten Kompensationseinrichtung (138, 136) zum Auswählen der zweiten Spannung aus einer Vielzahl verschiedener möglicher Spannungen und dadurch Auswählen einer Spannungsdifferenz zwischen der ersten und der zweiten Spannung gekoppelt ist; und
Bereitstellen einer Speichereinrichtung (16), die mit der Oszillatoreinrichtung (14) zum Bereitstellen von Signalen für die Oszillatoreinrichtung (14) zum Trimmen der Frequenz des Systemtaktes gekoppelt ist.

11. Verfahren nach Anspruch 10, ferner einschließend den Schritt des Bereitstellens einer Mikrocontroller-Logikeinrichtung (12), die darin gespeicherte Trimmdaten (22) zum Bereitstellen der Trimmdaten (22) für die Speichereinrichtung (16) aufweist.

12. Verfahren nach Anspruch 11, wobei der Schritt des Bereitstellens der Mikrocontroller-Logikeinrichtung (12) auch den Schritt des Bereitstellens einer Oszillator-Steuereinrichtung (24) darin zum Auswählen zwischen einer Verwendung der Oszillatoreinrichtung (14) innerhalb des Mikrocontrollers (10) für den Systemtakt und einer Verwendung einer externen Oszillatorquelle (34) für den Systemtakt einschließt.

13. Verfahren nach Anspruch 12, ferner einschließend den Schritt des Bereitstellens einer Oszillator-Logikeinrichtung (20), die mit der Mikrocontroller-Logikeinrichtung (12), der Oszillatoreinrichtung (14) und der externen Oszillatorquelle (34) zum Bereitstellen des Systemtakts für den Mikrocontroller (10) von einer, der Oszillatoreinrichtung (14) und der externen Oszillatorquelle (34) in Erwiderung auf den Empfang eines Signals von der Oszillator-Steuereinrichtung (24) gekoppelt ist.

14. Verfahren nach Anspruch 11, bei dem der Schritt des Bereitstellens der Speichereinrichtung (16) den Schritt des Bereitstellens eines statischen Direktzugriffsspeichers (SRAM) mit einer Steuerregistereinrichtung (18) zum Speichern der Trimmdaten (22) und Zuführen der Trimmdaten (22) zu der Oszillatoreinrichtung (14) aufweist.

15. Verfahren nach Anspruch 14, ferner einschließend den Schritt des Bereitstellens von SRAM-Adress-, Daten-, Leseund Schreib-Leitungen zwischen der Mikrocontroller-Logikeinrichtung (12) und dem SRAM.

16. Verfahren nach Anspruch 14, ferner einschließend den Schritt des Bereitstellens einer Vielzahl von Leitungen, welche die Steuerregistereinrichtung (18) mit der Oszillatoreinrichtung (14) zum Übertragen der Trimmdaten (22) zu der Oszillatoreinrichtung (14) koppeln.

17. Verfahren nach Anspruch 10, bei dem die Speichereinrichtung (16) innerhalb des Mikrocontrollers (10) angeordnet wird.

18. Verfahren nach Anspruch 11, ferner einschließend den Schritt des Bereitstellens einer Trimmdaten-(22)-Einstelleinrichtung innerhalb der Mikrocontroller-Logikeinrichtung (12) zum Ändern der Trimmdaten (22), nachdem die Trimmdaten (22) zu der Speichereinrichtung (16) übertragen wurden.

19. Mikrocontroller-Schaltung mit Firmware-auswählbarer Oszillatortrimmung in Kombination aufweisend:
einen Mikrocontroller (10);
**dadurch gekennzeichnet, dass** die Mikrocontroller-Schaltung in Kombination mit dem Mikrocontroller (10) eine Oszillatoreinrichtung (14) aufweist, die innerhalb des Mikrocontrollers (10) zum Bereitstellen eines Systemtaktsignals für den Mikrocontroller (10) angeordnet ist, wobei die Oszillatoreinrichtung (14) ein oszillierendes Signal mit einer vorbestimmten Frequenz über ein in Reihe geschaltetes Widerstands-Kondensator-(RC)-Netz durch Sicherstellen erzeugt, dass das oszillierende Signal genau zwischen einer ersten und einer zweiten Spannung oszilliert, die von einer Speisespannungsquelle erzeugt werden, wobei die Oszillationsfrequenz durch sowohl die Zeitkonstante des RC-Netzes als auch die Differenz zwischen der ersten und der zweiten Spannung bestimmt wird, wobei die Oszillatoreinrichtung (14) in Kombination aufweist:
eine Ladungs-Entladungs-Einrichtung (200) zum Entladen einer Spannung über den Kondensator (140), beginnend, wenn die Spannung des oszillierenden Signals eine erste Schwellenspannung überschreitet, und zum Laden der Spannung über den Kondensator (140), beginnend, wenn die Spannung des oszillierenden Signals unter eine zweite Schwellenspannung fällt;
eine erste Abtasteinrichtung (240, 126), welche mit der Ladungs-Entladungs-Einrichtung (200) zum Erzielen einer ersten abgetasteten Spannung des oszillierenden Signals nach dem Beginn des Entladens der Spannung über den Kondensator (140) gekoppelt ist;
eine erste Kompensationseinrichtung (130, 128), die mit der ersten Abtasteinrichtung (240, 126) zum Einstellen der ersten Schwellenspannung als die erste Spannung gekoppelt ist, welche durch eine Spannungsdifferenz zwischen der ersten Spannung und der ersten abgetasteten Spannung modifiziert wird;
eine zweite Abtasteinrichtung (320, 134), die mit der Ladungs-Entladungs-Einrichtung (200) zum Erzielen einer zweiten abgetasteten Spannung des oszillierenden Signals nach dem Beginn des Ladens der Spannung über den Kondensator (140) gekoppelt ist;
eine zweite Kompensationseinrichtung (138, 136), die mit der zweiten Abtasteinrichtung (320, 134) zum Einstellen der zweiten Schwellenspannung als der zweiten Spannung gekoppelt ist, welche durch eine Spannungsdifferenz zwischen der zweiten Spannung und der zweiten abgetasteten Spannung modifiziert wird; und
eine Differenzspannungs-Einstelleinrichtung (340), welche mit der zweiten Kompensationseinrichtung (138, 136) zum Auswählen der zweiten Spannung aus einer Vielzahl verschiedener möglicher Spannungen und dadurch Auswählen einer Spannungsdifferenz zwischen der ersten und der zweiten Spannung gekoppelt ist;
eine Speichereinrichtung (16), die mit der Oszillatoreinrichtung (14) zum Bereitstellen von Signalen für die Oszillatoreinrichtung (14) zum Trimmen der Frequenz des Systemtakts gekoppelt ist;
eine Mikrocontroller-Logikeinrichtung (12) mit darin gespeicherten Trimmdaten (22) zum Liefern der Trimmdaten (22) zu der Speichereinrichtung (16);
wobei die Mikrocontroller-Logikeinrichtung (12) auch eine Oszillator-Steuereinrichtung (24) in dieser zum Auswählen zwischen einer Verwendung der Oszillatoreinrichtung (14) innerhalb des Mikrocontrollers (10) für den Systemtakt und einer Verwendung einer externen Oszillatorquelle (34) für den Systemtakt einschließt;
eine Oszillator-Logikeinrichtung (20), welche mit der Mikrocontroller-Logikeinrichtung (12), der Oszillatoreinrichtung (14) und der externen Oszillatorquelle (34) zum Bereitstellen des Systemtakts für den Mikrocontroller (10) von einer, der Oszillatoreinrichtung (14) und der externen Oszillatorquelle (34) in Erwiderung auf den Empfang eines Signals von der Oszillator-Steuereinrichtung (24) gekoppelt ist;
wobei die Speichereinrichtung (16) einen statischen Direktzugriffsspeicher (SRAM) aufweist, welcher eine Steuerregistereinrichtung (18) zum Speichern der Trimmdaten (22) und Zuführen der Trimmdaten (22) zu der Oszillatoreinrichtung (14) aufweist; und
eine Trimmdaten-Einstelleinrichtung innerhalb der Mikrocontroller-Logikeinrichtung (12) zum Ändern der Trimmdaten (22), nachdem die Trimmdaten (22) zu der Speichereinrichtung (16) übertragen wurden.

## Revendications

1. Circuit microcontrôleur pourvu d'un système d'ajustement d'oscillateur pouvant être sélectionné par micrologiciel comprenant:
un microcontrôleur (10);
dans lequel ledit circuit microcontrôleur comprend, en combinaison avec le microcontrôleur (10), des moyens formant oscillateur (14) situés dans ledit microcontrôleur (10) pour fournir un signal d'horloge système audit microcontrôleur (10), dans lequel lesdits moyens formant oscillateur (14) engendrent un signal oscillant de fréquence prédéterminée sur un circuit résistance-capacité série (RC) en assurant que le signal oscillant oscille de façon précise entre des première et deuxième tensions engendrées à partir d'une source de tension d'alimentation où la fréquence d'oscillation est déterminée à la fois par la constante de temps du circuit RC et par la différence entre les première et deuxième tensions, lesdits moyens formant oscillateur (14) comprenant, en combinaison :
des moyens de charge-décharge (200) pour décharger une tension sur le condensateur (140), au moment où la tension du signal oscillant dépasse une première tension de seuil et pour charger ladite tension sur ledit condensateur (140) au moment où la tension du signal oscillant chute en dessous d'une deuxième tension de seuil ;
des premiers moyens d'échantillonnage (240, 126) reliés audits moyens de charge-décharge (200) pour obtenir une première tension échantillonnée du signal oscillant au début de la décharge de ladite tension sur le condensateur (140);
des premiers moyens de compensation (130, 128) reliés audits premiers moyens d'échantillonnage (240, 126) pour ajuster ladite première tension de seuil à une première tension modifiée d'une différence de tension entre la première tension et ladite première tension échantillonnée ;
des deuxièmes moyens d'échantillonnage (320, 134) reliés audits moyens de charge-décharge (200) pour obtenir une deuxième tension échantillonnée du signal oscillant au début de la charge de ladite tension sur le condensateur (140) ;
des deuxièmes moyens de compensation (138, 136) reliés audits deuxièmes moyens d'échantillonnage (320, 134) pour ajuster ladite deuxième tension de seuil à une deuxième tension modifiée d'une différence de tension entre la deuxième tension et ladite deuxième tension échantillonnée ; et
des moyens de fixation de tension différentielle (340) reliés audits deuxièmes moyens de compensation (138, 136) pour sélectionner la deuxième tension parmi une pluralité de différentes tensions possibles et sélectionnant ainsi une différence de tension entre les première et deuxième tensions, et
des moyens formant mémoire (16) reliés audits moyens formant oscillateur (14) pour fournir des signaux audits moyens formant oscillateur (14) pour ajuster la fréquence de ladite horloge système.

2. Circuit microcontrôleur selon la revendication 1, comprenant en outre des moyens logiques de microcontrôleur (12) dans lesquels des données d'ajustement (22) sont stockées pour fournir lesdites données d'ajustement audits moyens formant mémoire (16).

3. Circuit microcontrôleur selon la revendication 2, dans lequel lesdits moyens logiques de microcontrôleur (12) comprennent en outre des moyens de commande de l'oscillateur (24) pour la sélection entre l'utilisation desdits moyens formant oscillateur (14) internes audit microcontrôleur (10) pour ladite horloge système et l'utilisation d'une source d'oscillation externe (34) pour ladite horloge système.

4. Circuit microcontrôleur selon la revendication 3, comprenant en outre des moyens logiques d'oscillateur (20) reliés audits moyens logiques de microcontrôleur (12), audits moyens formant oscillateur (14) et à ladite source d'oscillation externe (34) pour fournir, en réponse à la réception d'un signal desdits moyens de commande de l'oscillateur (24), ladite horloge système audit microcontrôleur (10) à partir desdits moyens formant oscillateur (14) ou de ladite source d'oscillation externe (34).

5. Circuit microcontrôleur selon la revendication 2, dans lequel lesdits moyens formant mémoire (16) comprennent une mémoire à accès direct statique (SRAM) ayant des moyens formant registre de commande (18) pour stocker lesdites données d'ajustement (22) et fournir lesdites données d'ajustement (22) audits moyens formant oscillateur (14).

6. Circuit microcontrôleur selon la revendication 5, comprenant en outre des lignes d'adresses, de données, de lecture et d'écriture SRAM entre lesdits moyens logiques de microcontrôleur (12) et ladite SRAM.

7. Circuit microcontrôleur selon la revendication 5, comprenant en outre une pluralité de lignes reliant lesdits moyens formant registre de commande (18) avec lesdits moyens formant oscillateur (14) pour transférer lesdites données d'ajustement (22) audits moyens formant oscillateur (14).

8. Circuit microcontrôleur selon la revendication 1, dans lequel lesdits moyens formant mémoire (16) se trouvent dans ledit microcontrôleur (10).

9. Circuit microcontrôleur selon la revendication 2, comprenant en outre des moyens d'ajustement des données d'ajustement (22) dans lesdits moyens logiques de microcontrôleur (12) pour modifier lesdites données d'ajustement (22) après que lesdites données d'ajustement (22) ont été transférées audits moyens formant mémoire (16).

10. Procédé d'exploitation d'un circuit microcontrôleur pourvu d'un système d'ajustement d'oscillateur pouvant être sélectionné par micrologiciel comprenant les étapes consistant à :
fournir un microcontrôleur (10) ;
fournir un signal d'horloge système audit microcontrôleur (10), dans lequel ledit procédé comprend en outre les étapes consistant à fournir ledit signal d'horloge système à partir des moyens formant oscillateur (14) situés dans ledit microcontrôleur (10), lesdits moyens formant oscillateur (14) engendrant un signal oscillant de fréquence prédéterminée sur un circuit résistance-capacité série (RC) en assurant que le signal oscillant oscille de façon précise entre des première et deuxième tensions engendrées à partir d'une source de tension d'alimentation où la fréquence d'oscillation est déterminée à la fois par la constante de temps du circuit RC et par la différence entre les première et deuxième tensions, lesdits moyens formant oscillateur (14) comprenant, en combinaison :
des moyens de charge-décharge (200) pour décharger une tension sur le condensateur (140), au moment où la tension du signal oscillant dépasse une première tension de seuil et pour charger ladite tension sur ledit condensateur (140) au moment où la tension du signal oscillant chute en dessous d'une deuxième tension de seuil ;
des premiers moyens d'échantillonnage (240, 126) reliés audits moyens de charge-décharge (200) pour obtenir une première tension échantillonnée du signal oscillant au début de la décharge de ladite tension sur le condensateur (140) ;
des premiers moyens de compensation (130, 128) reliés audits premiers moyens d'échantillonnage (240, 126) pour ajuster ladite première tension de seuil à une première tension modifiée d'une différence de tension entre la première tension et ladite première tension échantillonnée ;
des deuxièmes moyens d'échantillonnage (320, 134) reliés audits moyens de charge-décharge (200) pour obtenir une deuxième tension échantillonnée du signal oscillant au début de la charge de ladite tension sur le condensateur (140);
des deuxièmes moyens de compensation (138, 136) reliés audits deuxièmes moyens d'échantillonnage (320, 134) pour ajuster ladite deuxième tension de seuil à une deuxième tension modifiée d'une différence de tension entre la deuxième tension et ladite deuxième tension échantillonnée, et
des moyens de fixation de tension différentielle (340) reliés audits deuxièmes moyens de compensation (138, 136) pour sélectionner la deuxième tension parmi une pluralité de différentes tensions possibles et sélectionnant ainsi une différence de tension entre les première et deuxième tensions, et
des moyens formant mémoire (16) reliés audits moyens formant oscillateur (14) pour fournir des signaux audits moyens formant oscillateur (14) pour ajuster la fréquence de ladite horloge système.

11. Procédé selon la revendication 10, comprenant en outre l'étape consistant à fournir des moyens logiques de microcontrôleur (12) dans lesquels sont stockées des données d'ajustement (22) pour fournir lesdites données d'ajustement (22) audits moyens formant mémoire (16).

12. Procédé selon la revendication 11, dans lequel ladite étape consistant à fournir lesdits moyens logiques de microcontrôleur (12) comprend en outre l'étape consistant à fournir des moyens de commande de l'oscillateur (24) pour la sélection entre l'utilisation desdits moyens formant oscillateur (14) internes audit microcontrôleur (10) pour ladite horloge système et l'utilisation d'une source d'oscillation externe (34) pour ladite horloge système.

13. Procédé selon la revendication 12, comprenant en outre l'étape consistant à fournir des moyens logiques d'oscillateur (20) reliés audits moyens logiques de microcontrôleur (12), audits moyens formant oscillateur (14) et à ladite source d'oscillation externe (34) pour fournir, en réponse à la réception d'un signal desdits moyens de commande de l'oscillateur (24), ladite horloge système audit microcontrôleur (10) à partir desdits moyens formant oscillateur (14) ou de ladite source d'oscillation externe (34).

14. Procédé selon la revendication 11, dans lequel ladite étape consistant à fournir lesdits moyens formant mémoire (16) comprend l'étape consistant à fournir une mémoire à accès direct statique (SRAM) ayant des moyens formant registre de commande (18) pour stocker lesdites données d'ajustement (22) et fournir lesdites données d'ajustement (22) audits moyens formant oscillateur (14).

15. Procédé selon la revendication 14, comprenant en outre l'étape consistant à fournir des lignes d'adresses, de données, de lecture et d'écriture SRAM entre les moyens logiques de microcontrôleur (12) et ladite SRAM.

16. Procédé selon la revendication 14, comprenant en outre l'étape consistant à fournir une pluralité de lignes reliant lesdits moyens formant registre de commande (18) avec lesdits moyens formant oscillateur (14) pour transférer lesdites données d'ajustement (22) audits moyens formant oscillateur (14).

17. Procédé selon la revendication 10, dans lequel lesdits moyens formant mémoire (16) se trouvent dans ledit microcontrôleur (10).

18. Procédé selon la revendication 11 comprenant en outre l'étape consistant à fournir des moyens d'ajustement des données d'ajustement (22) dans les moyens logiques de microcontrôleur (12) pour modifier lesdites données d'ajustement (22) après que lesdites données d'ajustement (22) ont été transférées audits moyens mémoires (16).

19. Circuit microcontrôleur pourvu d'un système d'ajustement d'oscillateur pouvant être sélectionné par micrologiciel comprenant, en combinaison:
un microcontrôleur (10);
dans lequel ledit circuit microcontrôleur comprend, en combinaison avec ledit microcontrôleur (10), des moyens formant oscillateur situés dans ledit microcontrôleur (10) pour fournir un signal d'horloge système pour ledit microcontrôleur (10), dans lequel lesdits moyens formant oscillateur (14) engendrent un signal oscillant de fréquence prédéterminée sur un circuit résistance-capacité série (RC) en assurant que le signal oscillant oscille de façon précise entre des première et deuxième tensions engendrées à partir d'une source de tension d'alimentation où la fréquence d'oscillation est déterminée à la fois par la constante de temps du circuit RC et par la différence entre les première et deuxième tensions, lesdits moyens formant oscillateur(14) comprenant, en combinaison :
des moyens de charge-décharge (200) pour décharger une tension sur le condensateur (140), au moment où la tension du signal oscillant dépasse une première tension de seuil et pour charger ladite tension sur ledit condensateur (140) au moment où la tension du signal oscillant chute en dessous d'une deuxième tension de seuil;
des premiers moyens d'échantillonnage (240, 126) reliés audits moyens de charge-décharge (200) pour obtenir une première tension échantillonnée du signal oscillant au début de la décharge de ladite tension sur le condensateur (140);
des premiers moyens de compensation (130, 128) reliés audits premiers moyens d'échantillonnage (240, 126) pour ajuster ladite première tension de seuil à une première tension modifiée d'une différence de tension entre la première tension et ladite première tension échantillonnée;
des deuxièmes moyens d'échantillonnage (320, 134) reliés audits moyens de charge-décharge (200) pour obtenir une deuxième tension échantillonnée du signal oscillant au début de la charge de ladite tension sur le condensateur (140);
des deuxièmes moyens de compensation (138, 136) reliés audits deuxièmes moyens d'échantillonnage (320, 134) pour ajuster ladite deuxième tension de seuil à une deuxième tension modifiée d'une différence de tension entre la deuxième tension et ladite deuxième tension échantillonnée ; et
des moyens de fixation de tension différentielle (340) reliés audits deuxièmes moyens de compensation (138, 136) pour sélectionner la deuxième tension parmi une pluralité de différentes tensions possibles et sélectionnant ainsi une différence de tension entre les première et deuxième tensions,
des moyens formant mémoire (16) reliés audits moyens formant oscillateur (14) pour fournir des signaux audits moyens formant oscillateur (14) pour ajuster la fréquence de ladite horloge système;
des moyens logiques de microcontrôleur (12) dans lesquels sont stockées des données d'ajustement (22) pour fournir lesdites données d'ajustement (22) audits moyens formant mémoire (16);
lesdits moyens logiques de microcontrôleur (12) comprenant en outre des moyens de commande de l'oscillateur (24) pour la sélection entre l'utilisation desdits moyens formant oscillateur (14) internes audit microcontrôleur (10) pour ladite horloge système et l'utilisation d'une source d'oscillation externe (34) pour ladite horloge système,
des moyens logiques d'oscillateur (20) reliés audits moyens logiques de microcontrôleur (12), audits moyens formant oscillateur (14) et à ladite source d'oscillation externe (34) pour fournir, en réponse à la réception d'un signal desdits moyens de commande de l'oscillateur (24), ladite horloge système audit microcontrôleur (10) à partir desdits moyens formant oscillateur (14) ou de ladite source d'oscillation externe (34);
lesdits moyens formant mémoire (16) comprennent une mémoire à accès direct statique (SRAM) ayant des moyens formant registre de commande (18) pour stocker lesdites données d'ajustement (22) et fournir lesdites données d'ajustement (22) audits moyens formant oscillateur (14); et
des moyens d'ajustement des données d'ajustement dans lesdits moyens logiques de microcontrôleur (12) pour modifier lesdites données d'ajustement (22) après que lesdites données d'ajustement (22) ont été transférées audits moyens formant mémoire (16).
